# EUROPÄISCHE PATENTSCHRIFT

(11) **EP 0 608 661 B1**
(45) Veröffentlichungstag und Bekanntmachung des Hinweises auf die Patenterteilung: **07.01.1998**
(21) Anmeldenummer: 93810052.6
(22) Anmeldetag: 26.01.1993
(51) Int. Cl.: G03F 7/12, G03F 7/16, B05C 9/04

(54) **Einrichtung zur Beschichtung von Drucksieben**
Device for coating of printing screens
Dispositif pour le revêtement des écrans d'impression

(43) Veröffentlichungstag der Anmeldung: 03.08.1994
(73) Patentinhaber: H.U. GRÜNIG AG, CH-3150 Schwarzenburg (CH)
(72) Erfinder: Grünig, Hans-Ulrich, CH-3150 Schwarzenburg (CH)
(74) Vertreter: Fischer, Franz Josef

(56) Entgegenhaltungen:
- EP-A- 0 026 538
- EP-A- 0 135 682
- EP-A- 0 428 121
- DE-A- 2 914 252
- DE-A- 4 119 448
- DE-C- 3 932 955

## Beschreibung

Die vorliegende Erfindung bezieht sich auf eine Einrichtung zur Beschichtung von Drucksieben gemäss dem Oberbegriff des Patentanspruchs 1.

Derartige Einrichtungen sind bekannt. So zeigt beispielsweise die EP-A-0 026 538 eine Vorrichtung zum zweiseitigen Beschichten eines ebenen Drucksiebes mit einer Fotoemulsion. Diese Vorrichtung besteht aus einem Ständerrahmen, in welchen ein zu beschichtendes Drucksieb einsetzbar und durch entsprechende Halterungen gehalten ist. An den beiden vertikalen Pfosten des Ständerrahmens ist je ein nach oben und unten verschiebbarer Wagen angebracht. Die beiden Wagen sind mit zwei Querstangen miteinander verbunden, welche Querstangen längs der beiden Seiten des Gewebes verlaufen. In die Querstangen ist eine Rakel einhängbar. Die Querstangen sind so an den Wagen gehalten, dass eine An- und Abstellbewegung der beiden Rakel bezüglich des Drucksiebes sowie eine Schwenkbewegung um die Rakelvorderkante ermöglicht wird.

Die beiden Querstangen, an welchen die Rakel eingehängt werden können, sind je an ihrem stirnseitigen Ende in den entsprechenden Wagen gehalten und abgestützt. Infolge dieser Halterung der Querstangen ist bei angestellter Rakel an das zu beschichtende Drucksieb der Anpressdruck an den Randbereichen des auf einen Schablonenrahmen aufgespannten Drucksiebes am grössten. Infolge der Biegung, die die Querstangen und demzufolge die darauf eingehängten Rakel erfahren, nimmt der Anpressdruck gegen das Drucksieb in dessen mittlerem Bereich ab. Dieser Effekt wird noch dadurch unterstützt, dass das Drucksieb in seinem mittleren Bereich, in welchem die Distanz zum Schablonenrahmen am grössten ist, durch den Anpressdruck der Rakel zusätzlich noch ausweichen kann. Dadurch besteht die Gefahr, insbesondere bei grossflächigen zu beschichtenden Drucksieben, dass die Schicht der Fotoemulsion nicht über die ganze Breite des Drucksiebes eine konstante Dicke aufweist. Derartige Unterschiede in der Schichtdicke können einen negativen Einfluss auf die Weiterverarbeitung des beschichteten Drucksiebes bis hin zur Druckqualität des zu druckenden Sujet haben.

Da die Querstangen an jeweils beiden Enden stirnseitig gehalten und abgestützt sind, und demzufolge die auf Schablonenrahmen aufgespannten und zu beschichtenden Drucksiebe zwischen den Querstangen untergebracht werden müssen, müssen die beiden Pfosten des Ständerrahmens einen gegenseitigen Abstand voneinander haben, der entsprechend dem grössten Schablonenrahmen, dessen Drucksieb beschichtet werden soll, ausgelegt ist. Dies bedeutet aber, dass der Ständerrahmen für kleinere zu beschichtende Drucksiebe zu gross dimensioniert ist. Die Länge der Querstangen ist fest, so dass das Problem der Durchbiegung und des Ausweichens des Drucksiebes auch für kleinere Schablonenrahmen bestehen bleibt.

Die Aufgabe der Erfindung besteht nun darin, eine Einrichtung zur Beschichtung von Drucksieben zu schaffen, welche Ungenauigkeiten in der Schichtdicke, die durch die Durchbiegung der Rakel bzw. der Rakelaufhängung und durch das Ausweichen des Drucksiebes im mittleren Bereich des Schablonenrahmens entstehen können, wesentlich verbessert.

Erfindungsgemäss erfolgt die Lösung dieser Aufgabe durch die in der Kennzeichnung des Anspruchs 1 angegebenen Merkmale.

Durch die Halterung im mittleren Bereich der Längsausdehnung der Rakel wird der Vorteil erreicht, dass die Durchbiegung der Rakel beim Andrücken an das Drucksieb in die gleiche Richtung erfolgt, wie das Drucksieb auszuweichen bestrebt ist. Dadurch ist der Anpressdruck über die gesamte Rakellänge gleichmässiger verteilt, insbesondere beim einseitigen Beschichten des Drucksiebes, so dass die Genauigkeit der Schichtdicke wesentlich verbessert wird.

Damit nun die über die Gesamtlänge des Drucksiebes durchgehende Rakel wie bei der bekannten Vorrichtung ebenfalls an- und abgestellt werden kann und dass ein Hochschwenken der Rakel um die Rakelvorderkante erfolgen kann, ist die Rakel in vorteilhafter Weise in eine Halterung einhängbar, die mit Führungen ausgerüstet ist, die entlang Führungsbahnen, die am Wagen angeordnet sind, über Betätigungsmittel verschiebbar ist. Hierbei weisen die Führungen und die Führungsbahnen die Form eines Kreisbogens auf, dessen Zentren in der Rakelkante der Rakel liegen.

Das An- und Abstellen der Rakel bezüglich des Drucksiebes kann in einfacher Weise dadurch erreicht werden, dass die Führungen, entlang denen die Halterung verschiebbar ist, auf Schwenkhebeln angeordnet sind, die um eine Schwenkachse über ein Betätigungsmittel schwenkbar sind, welche Schwenkachse parallel zur Rakelkante ausgerichtet ist.

In vorteilhafter Weise besteht die Halterung für die Aufnahme der Rakel aus einem Vierkantprofil. Das Vierkantprofil ist mit zwei quer zur Längsausrichtung stehenden Seitenwänden ausgerüstet, in welchen die Führungen angebracht sind. Hierbei kann das Vierkantprofil beidseits über die Seitenwände hinausragen, so dass die in das Vierkantprofil einhängbare Rakel über einen grösseren Teilbereich seiner Längsausdehnung durch das Vierkantprofil verstärkt wird, wodurch vermieden wird, dass sich die Rakel, insbesondere wenn es sich um sehr lange Rakel handelt, in Längsrichtung verwindet.

Die Betätigungsmittel zum Verfahren der Halterung entlang der Führungsbahnen sowie die Betätigungsmittel zum Verschwenken der schwenkbaren Hebel um die Schwenkachse bestehen in vorteilhafter Weise je aus einem pneumatisch betätigbaren Zylinder, wovon ein Ende schwenkbar mit dem Wagen verbunden ist, während das andere Ende schwenkbar an der Halterung bzw. an den schwenkbaren Hebeln angelenkt ist. Hierbei können die Hubendlagen der entsprechenden Zylinder als Endlagen der zu bewegenden Teile verwendet werden.

Damit die Rakel beim An- und Abstellen an das Drucksieb im wesentlichen die gleiche Lage beibehalten, sind die beiden Zylinder bezüglich der An- und Abstellrichtung hintereinander und praktisch parallel angeordnet. Dadurch ergibt sich, dass die Rakel während der Schwenkbewegung der Hebel praktisch horizontal gehalten werden.

Da die vertikal verfahrbaren Wagen zur Aufnahme der Halterung ein Rakel im mittleren Bereich der Rakel angeordnet sind, die Rakel demzufolge freie Enden haben, und da die Wagen entlang Säulen des Ständerrahmens verfahrbar sind, die demzufolge ebenfalls im mittleren Bereich des Drucksiebes stehen, können mit dieser Einrichtung unterschiedlich grosse Drucksiebe beschichtet werden, wobei lediglich die Länge der Rakel zu verändern ist. Die Grösse des Ständerrahmens muss also nur eine entsprechende Höhe aufweisen, damit alle Grössen von Drucksieben, die beschichtet werden sollen, bearbeitet werden können, während die Querabmessung des Ständerrahmens unverändert eng gehalten werden kann.

Eine Ausführung der erfindungsgemässen Einrichtung wird nachfolgend anhand der Zeichnungen beispielhaft näher erläutert. Es zeigt:
**Fig. 1** eine räumliche Darstellung einer Gesamteinrichtung zum Beschichten eines Drucksiebes;
**Fig. 2** eine Seitenansicht der Einrichtung gemäss Fig. 1;
**Fig. 3** schematisch eine Schnittdarstellung entlang Linie III-III gemäss Fig. 4 durch die Halterung der Rakel, wie sie im verfahrbaren Wagen untergebracht ist, in der vom Drucksieb abgestellten Position;
**Fig. 4** eine schematische Darstellung der Rakelhalterung gemäss Fig. 3, von der Drucksiebseite her gesehen;
**Fig. 5** schematisch eine Schnittdarstellung der Rakelhalterung gemäss Fig. 3, in der an das Drucksieb angestellten Position;
**Fig. 6** schematisch eine Schnittdarstellung der Rakelhalterung gemäss Fig. 3, in der angestellten und verschwenkten Position.

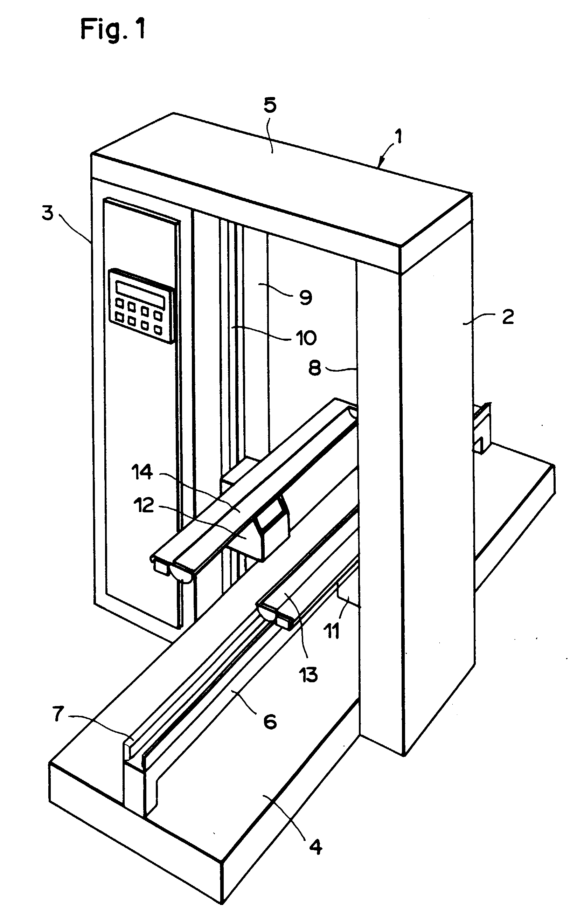

Wie aus der schematischen Darstellung gemäss Fig. 1 ersichtlich ist, besteht die Einrichtung zur Beschichtung von Drucksieben aus einem Ständerrahmen 1, der aus zwei vertikalen Säulen 2 und 3, einem Sockel 4 und die beiden Säulen 2 und 3 verbindenden oberen Querträger 5 zusammengesetzt ist. Am Sockel 4 ist ein Fussstück 6 befestigt, welches horizontal quer zwischen den beiden Säulen 2 und 3 hindurchgeführt ist, und an dessen nach oben gerichteten Längsseite ein nach oben offenes U-Profil 7 angebracht ist.

An den beiden einander gegenüberliegenden Seiten 8 und 9 der beiden Säulen 2 bzw. 3 sind vertikal verlaufende Längsführungen 10 angebracht. Entlang dieser Längsführungen ist in bekannter Weise je ein Wagen 11 bzw. 12 vertikal verfahrbar angebracht. An jedem der Wagen 11 und 12 ist eine Rakel 13 bzw. 14 angebracht. Diese beiden Rakel 13 und 14 sind mit ihren Längsausrichtungen horizontal ausgerichtet und verlaufen parallel zur Längsausrichtung des U-Profils 7.

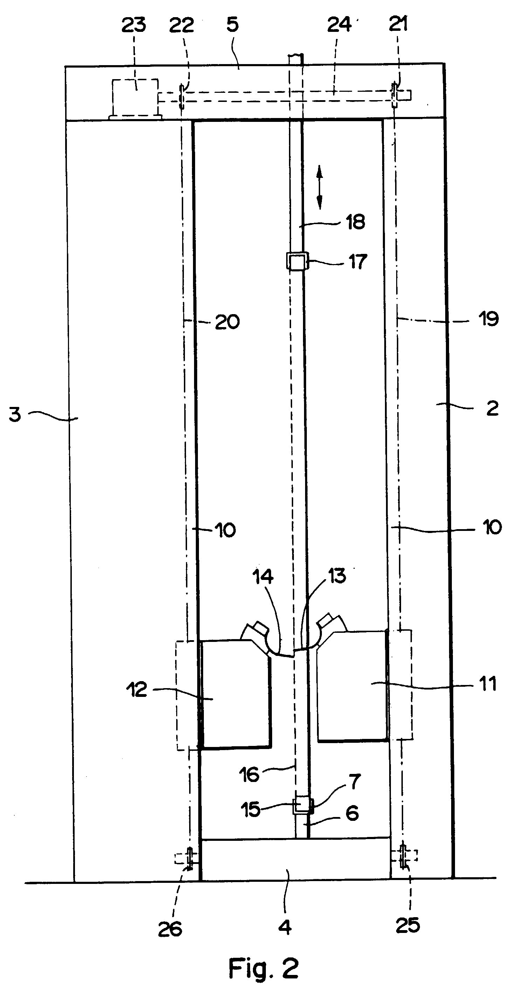

Wie aus Fig. 2 ersichtlich ist, kann in das U-Profil 7, das auf dem Fussstück 6 oberhalb des Sockels 4 befestigt ist, ein Schablonenrahmen 15, der mit einem Drucksieb 16 bespannt ist, eingeschoben werden. Der Schablonenrahmen 15 wird an seinem oberen Rahmenteil durch ein weiteres U-Profil 17 gehalten, welches nach unten offen ist, und welches durch eine Halterung 18 in nicht dargestellter, aber bekannter Weise am Querträger 5 höhenverstellbar gehalten ist. Der Schablonenrahmen 15 wird soweit entlang der U-Profile 7 und 17 in die Einrichtung eingeschoben, bis der mittlere Bereich des Drucksiebes 16, das auf dem Schablonenrahmen 15 aufgespannt ist, zwischen den beiden Säulen 2 und 3 liegt. Danach können die beiden Rakel 13 und 14 an das Drucksieb 16 angestellt und verschwenkt werden, wie nachfolgend noch näher beschrieben wird.

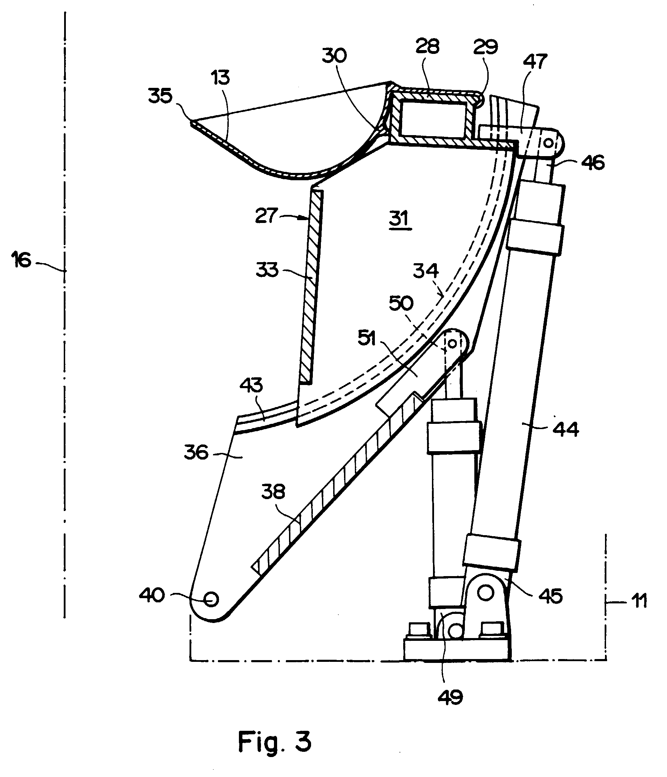

Zum Beschichten des Drucksiebes 16 mit einer Fotoemulsion wird in der Position der Rakel 13 und 14, wie sie in Fig. 1 und Fig. 3 dargestellt ist, die Fotoemulsion in den wannenförmigen Raum der Rakel 13 und 14 eingefüllt. Die Enden der Rakel 13 und 14 sind mit Seitenwänden abgeschlossen. Nach dem Anstellen der Rakel 13 und 14 an das Drucksieb 16 und dem Verschwenken der Rakel 13 und 14, wie es in Fig. 2 dargestellt ist, werden die beiden Wagen 11 und 12 entlang der Längsführungen 10 von unten nach oben verfahren. Hierzu erstreckt sich entlang der Längsführungen 10 in beiden Säulen 2 und 3 je ein endloses Antriebsglied 19 bzw. 20, welches Antriebsglied 19 und 20 über Antriebsrollen 21 und 22, die auf einer durch einen Motor 23 angetriebenen Welle 24 befestigt sind, antreibbar sind. Im Bereich des Sockels 4 sind entsprechende Umlenkrollen 25 und 26 angeordnet.

Nach dem Beendigen des Beschichtens des Drucksiebes 16 werden die Rakel 13 und 14 in die Ausgangslage zurückgeschwenkt und vom Drucksieb 16 abgestellt.

Selbstverständlich ist es auch möglich, nur eine Seite eines Drucksiebes 16 zu beschichten. Hierzu wird nur ein Rakel 13 oder 14 an das Drucksieb 16 angestellt, während das andere in der abgestellten Lage verharrt, wonach der vorher beschriebene Vorgang des Hochfahrens der Wagen 11 und 12 abläuft.

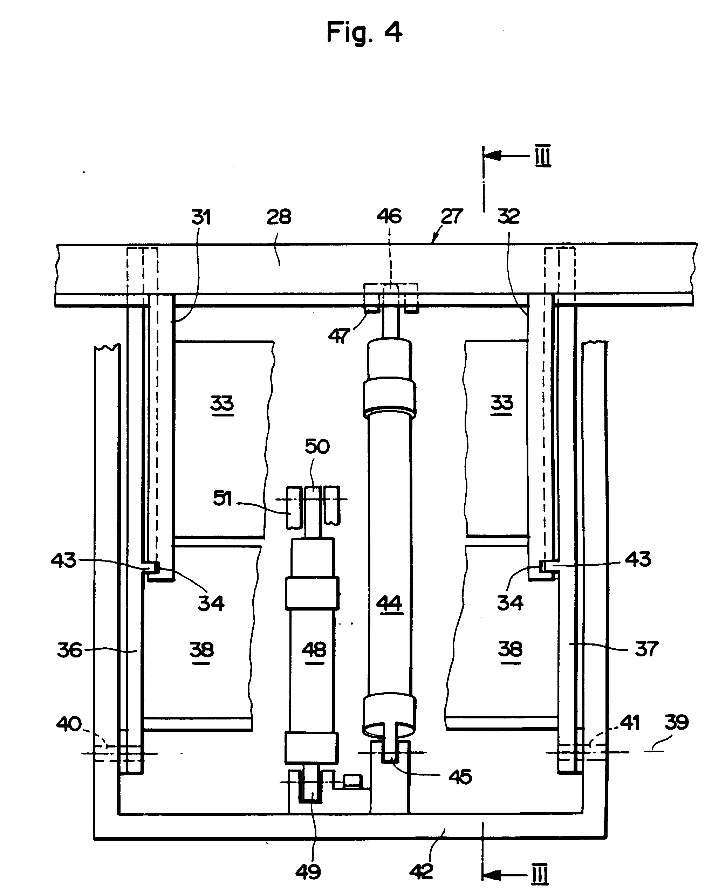

Wie in Fig. 3 dargestellt ist, ist die Rakel 13 in eine Halterung 27 einsetzbar, die im Wagen 11 angeordnet ist. Der Wagen 11 ist hierbei nur durch die strichpunktierten Linien angedeutet. Die Halterung 27 besteht aus einem Vierkantprofil 28, in welches die Rakel 13, die hierzu mit einem Haken 29 und einer Abstützkante 30 versehen ist, einhängbar ist. Am Vierkantprofil 28 sind in dessen mittleren Bereich zwei quer zur Längsausrichtung stehende Seitenwände 31 und 32 befestigt, wie aus Fig. 4 ersichtlich ist. Die beiden Seitenwände 31 und 32 sind neben dem Vierkantprofil 28 noch durch einen Steg 33 miteinander verbunden. An der äusseren Oberfläche der beiden Seitenwände 31 und 32 ist je eine Nut 34 eingebracht, die als Führung zur Verschwenkung der Halterung 27 dient. Diese Nut 34 folgt einem Kreisbogen, dessen Zentrum in der Vorderkante 35 des Rakels 13 liegt.

Parallel zu den Seitenwänden 31 und 32 und ausserhalb derselben sind zwei Hebel 36 und 37 angebracht. Diese beiden Hebel sind über einen Steg 38 miteinander verbunden. Die beiden Hebel 36 und 37 sind um eine Schwenkachse 39 schwenkbar, welche parallel zur Rakelkante des Rakels 13 verläuft. Die Schwenkachse 39 wird durch die Bolzen 40 und 41 gebildet, die im Gehäuse 42 des Wagens 11 befestigt sind.

In die den benachbarten Seitenwänden 31 und 32 zugewandten Oberflächen der Hebel 36 und 37 ist je ein kreisbogenförmiges, über die Oberfläche vorstehendes Ringsegment 43 angebracht. Das Zentrum dieser beiden Ringsegmente 43 liegt jeweils ebenfalls in der Vorderkante 35 der Rakel 13. Die Ringsegmente 43 der Hebel 36 und 37 greifen jeweils in die entsprechende Nut 34 der beiden Seitenwände 31 und 32 ein und bilden demzufolge für die Halterung 27 entsprechende Führungsbahnen.

Die Halterung 27 lässt sich demzufolge schwenkbar um die Vorderkante 35 der Rakel 13 verfahren. Diese Bewegung erfolgt durch einen pneumatischen Zylinder 44, dessen eines Ende 45 schwenkbar mit dem Wagen 11 verbunden ist. Das andere Ende 46 ist an der Halterung 27 angelenkt, wozu diese Halterung 27 mit einer entsprechenden Gelenkgabel 47 ausgestattet ist.

Die beiden über den Steg 38 miteinander verbundenen Hebel 36 und 37 sind um die Schwenkachse 39 schwenkbar, was über einen pneumatischen Zylinder 48 erfolgt, dessen eines Ende 49 schwenkbar mit dem Wagen 11 verbunden ist, während das andere Ende 50 über eine entsprechende Gelenkgabel 51 mit dem die beiden Hebel verbindenden Steg 38 gelenkig verbunden ist.

Der auf der anderen Seite des Drucksiebes 16 angeordnete Wagen 12 mit dem daran angebrachten Rakel 14 ist in identischer Weise wie der Wagen 11 ausgerüstet, so dass auf dessen Beschreibung verzichtet werden kann. In Fig. 3 und 4 ist die Rakel 13 in der vom Drucksieb 16 abgestellten Lage dargestellt, die Rakel 13 befindet sich in der nach unten geschwenkten Position. In dieser Stellung kann beispielsweise die Emulsion in die Wanne der Rakel 13 eingefüllt werden.

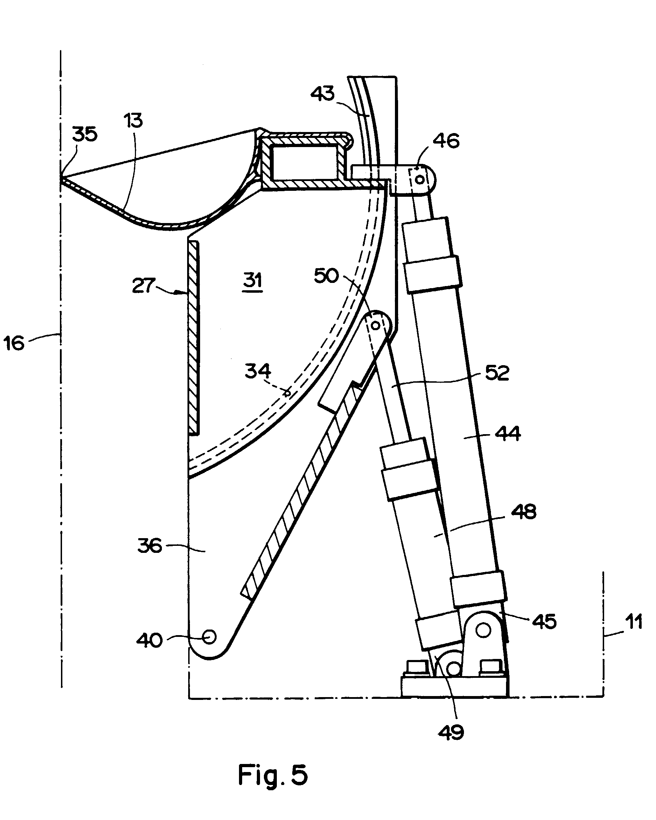

Fig. 5 zeigt die Halterung 27 gemäss Fig. 3 in der an das Drucksieb 16 angestellten Lage. Um von der abgestellten Lage, dargestellt in Fig. 3, zu dieser angestellten Lage zu kommen, wird der pneumatische Zylinder 48 betätigt. Hierdurch fährt die Kolbenstange 52 des Zylinders 48 hoch, die Hebel 36 und 37 (Fig. 4) werden um die Schwenkachse 39 hochgeschwenkt, bis die Vorderkante 35 der Rakel 13 an das Drucksieb 16 anstösst. Der Anpressdruck der Rakel 13 an das Drucksieb 16 kann durch Regulierung des Druckes der in den Zylinder 48 eingeführten Druckluft reguliert werden. Die Schwenkbewegung der Hebel 36 und 37 wird durch die Endlagen des Zylinders 48 begrenzt, so dass keine weiteren Anschläge erforderlich sind.

Während des Hochschwenkens der beiden Hebel 36 und 37 wird die Halterung 27 durch die beibehaltene Länge des Zylinders 44 entlang des Ringsegments 43 verschoben. Dieses Verschieben erfolgt durch die versetzten Befestigungspunkte, in welchen die beiden einen Enden 45 und 49 der beiden Zylinder 44 bzw. 48 mit dem Wagen 11 verbunden sind, und weil die Schwenkbewegung der beiden Zylinder 44 und 48 praktisch parallel erfolgt. Dadurch wird erreicht, dass die Rakel 13 praktisch horizontal gegen das Drucksieb 16 hin verschoben wird.

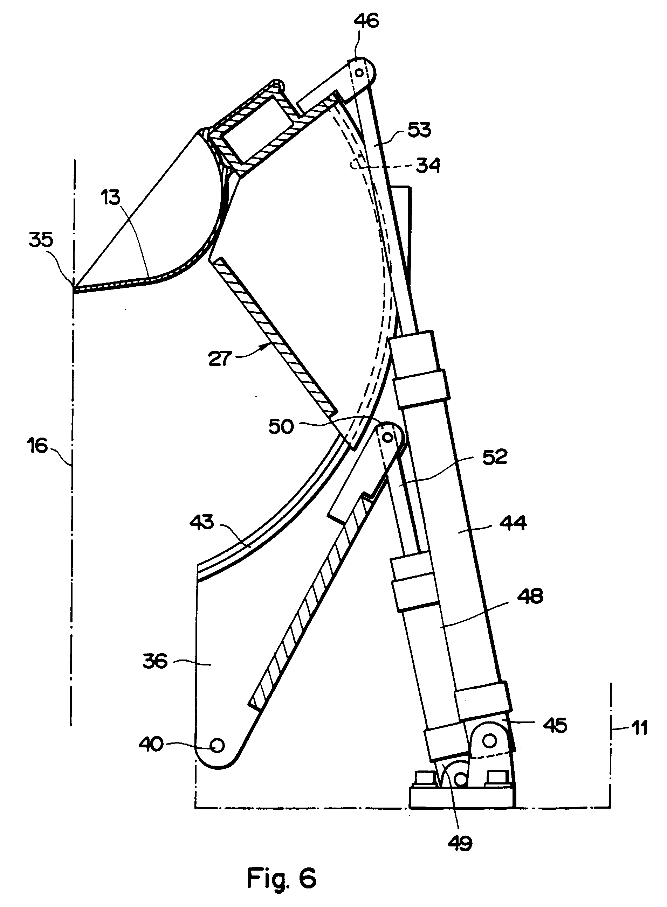

Wenn die Rakel 13 an das Drucksieb 16 angestellt ist, kann die Rakel 13 hochgeschwenkt werden, damit die in der Wanne der Rakel 13 sich befindende Emulsion in Kontakt mit der Oberfläche des Drucksiebes 16 gebracht wird und damit die Beschichtung erfolgen kann. Diese Lage ist in Fig. 6 dargestellt. Im angestellten Zustand der Rakel 13, dargestellt in Fig. 5, wird demgemäss der Zylinder 44 betätigt, die Kolbenstange 53 fährt aus dem Zylinder 44 aus. Dadurch wird bewirkt, dass die Halterung 27 mit ihren beidseits angebrachten Nuten 34 entlang der Ringsegmente 43 der Hebel 36 und 37 hochfährt. Da die Ringsegmente 43 und die Nuten 34 eine Kreisbogenform haben, deren Zentren in der Vorderkante 35 des Rakels 13 liegen, erfolgt dieses Verfahren der Halterung 27 entlang der Ringsegmente 43 als Schwenkbewegung um die Vorderkante 35 der Rakel 13. Die Endlagen dieser Schwenkbewegung der Halterung 27 ist durch die Hubendlagen des Zylinders 44 begrenzt, es sind keine zusätzlichen Anschläge erforderlich. In dieser in Fig. 6 dargestellten Lage wird der Wagen 11 wie vorgängig beschrieben, entlang des Drucksiebes 16 verfahren, das Drucksieb 16 wird beschichtet.

Nach Beendigung des Beschichtungsvorganges des Drucksiebes 16 wird durch Betätigen der beiden Zylinder 44 und 48 die in Fig. 3 dargestellte Ausgangslage wieder eingenommen. Das beschichtete Drucksieb 16 kann aus der Einrichtung entnommen werden, der beschriebene Vorgang kann wiederholt werden.

Mit dieser Einrichtung lässt sich ein genaues Beschichten des Drucksiebes erreichen, wobei der An- und Abstellmechanismus der Rakel 13 und 14 sowie der Hochschwenkmechanismus einfach aufgebaut sind.

## Patentansprüche

1. Einrichtung zur Beschichtung von Drucksieben, welche Einrichtung aus einem vertikalen Ständerrahmen besteht, der mit Halterungen zur vertikalen Aufnahme des zu beschichtenden Drucksiebes ausgerüstet ist, und in welchem vertikal verfahrbare Wagen angebracht sind, an welchen Wagen die Rakel befestigbar sind, wobei die Rakel an das zu beschichtende Drucksieb an- und abstellbar und um eine Schwenkachse, die durch die Rakelvorderkante verläuft, schwenkbar sind, dadurch gekennzeichnet, dass je die über die vordere Fläche bzw. die hintere Fläche des zu beschichtenden Drucksiebes (16) verfahrbare Rakel (13, 14) im mittleren Bereich ihrer Längsausdehnung durch je einen der vertikal verfahrbaren Wagen (11) bzw. (12) gehalten ist, während die Endbereiche frei sind.

2. Einrichtung nach Anspruch 1, dadurch gekennzeichnet, dass die Rakel (13, 14) in eine Halterung (27) einsetzbar ist, welche Halterung (27) mit Führungen (34) versehen ist, mit welchen Führungen (34) die Halterung (27) durch erste Betätigungsmittel (44) entlang Führungsbahnen (43), die am Wagen (11, 12) angeordnet sind, verschiebbar sind, wobei die Führungen (34) und die Führungsbahnen (43) die Form eines Kreisbogens haben, deren Zentren in der Rakelkante (35) der Rakel liegen.

3. Einrichtung nach Anspruch 2, dadurch gekennzeichnet, dass die Führungsbahnen (43) auf mindestens einem Hebel (36; 37) angeordnet sind, der um eine fest im Wagen (11, 12) angebrachte, parallel zur Rakelkante (35) ausgerichtete Schwenkachse (39) durch zweite Betätigungsmittel (48) schwenkbar ist.

4. Einrichtung nach Anspruch 2 oder 3, dadurch gekennzeichnet, dass die Halterung (27) für die Aufnahme der Rakel (13) oder (14) im wesentlichen aus einem Vierkantprofil (28) besteht, auf welchem die Rakel (13) oder (14), deren Länge im wesentlichen der Länge des zu beschichtenden Drucksiebs (16) entspricht, längseits einhängbar ist, und welches Vierkantprofil (28) im mittleren Bereich mit zwei quer zur Längsausrichtung stehenden Seitenwänden (31) und (32) ausgerüstet ist, in welchen Seitenwänden (31, 32) die Führungen aussenseitig in Form von Nuten (34) angebracht sind, welche Nuten (34) entlang des entsprechenden Kreisbogens verlaufen.

5. Einrichtung nach Anspruch 4, dadurch gekennzeichnet, dass aussenseitig der beiden Seitenwände (31, 32) der Halterung (27) je ein um die Schwenkachse (39) schwenkbarer Hebel (36, 37) angeordnet ist, die je ein in die der benachbarten Seitenwand (31) bzw. (32) zugewandten Oberfläche angebrachtes, aussenseitig vorstehendes, kreisförmiges Ringsegment (43) aufweisen, welches in die Nut (34) der entsprechenden Seitenwand (31) bzw. (32) eingreift, und dass die beiden schwenkbaren Hebel (36, 37) über einen Steg (38) miteinander verbunden sind.

6. Einrichtung nach einem der Ansprüche 2 bis 5, dadurch gekennzeichnet, dass die ersten Betätigungsmittel zum Verfahren der Halterung (27) entlang der Führungsbahnen (43) aus einem ersten pneumatisch betätigbaren Zylinder (44) bestehen, dessen eines Ende (45) schwenkbar mit dem Wagen (11) bzw. (12) verbunden ist, während das andere Ende (46) an der Halterung (27) angelenkt ist, und dass die Endlagen der verfahrbaren Halterung (27) durch die Hubendlagen des Zylinders (44) gegeben sind.

7. Einrichtung nach einem der Ansprüche 3 bis 6, dadurch gekennzeichnet, dass die zweiten Betätigungsmittel zum Verschwenken der schwenkbaren Hebel (36, 37) um die Schwenkachse (39) aus einem zweiten pneumatisch betätigbaren Zylinder (48) bestehen, dessen eines Ende (49) schwenkbar mit dem Wagen (11) bzw. (12) verbunden ist, während das andere Ende (50) an die schwenkbaren Hebel (36, 37) angelenkt ist, und dass die Endlagen der Schwenkbewegung durch die Hubendlagen des Zylinders (48) gegeben sind.

8. Einrichtung nach Anspruch 7, dadurch gekennzeichnet, dass der erste und zweite pneumatisch betätigbare Zylinder (44) und (48) im wesentlichen parallel zueinander angeordnet sind, und dass sie bezüglich der Schwenkachse (39), um welche die Hebel (36, 37) schwenkbar sind, einen unterschiedlichen Abstand haben.

9. Einrichtung nach einem der Ansprüche 1 bis 8, dadurch gekennzeichnet, dass der Ständerrahmen (1) zwei Säulen (2, 3) aufweist, zwischen welche beiden Säulen (2, 3) das zu beschichtende Drucksieb (16) einschiebbar und durch Halterungen (7, 17) gehalten ist, wobei der mittlere Bereich des Drucksiebs (16) zwischen die beiden Säulen (2, 3) zu stehen kommt, und dass je ein Wagen (11) bzw. (12) zur Aufnahme einer Rakel (13) bzw. (14) längs der Säule (2) bzw. (3) durch Antriebsmittel (19, 20, 21, 22, 23, 24, 25, 26) einzeln oder gemeinsam mit dem anderen Wagen (12) bzw. (11) verfahrbar ist.

## Claims

1. Device for coating of printing screens, which device comprises a vertical standing frame, which is equipped with holding elements to receive vertically the printing screen to be coated, and in which vertically movable carriages are mounted, on which carriages the squeegees can be fastened, the squeegees being pivotable placeable on and off the printing screen to be coated and about a pivot axis which runs through the front edge of the squeegee, characterised in that each squeegee (13, 14), which can travel over the front surface or the rear surface, respectively, of the printing screen (16) to be coated is held in the middle area of its longitudinal extent by one each of the vertically movable carriages (11) or (12), respectively, while the other ends are free.

2. Device according to claim 1, characterised in that the squeegee (13, 14) can be inserted into a holding element (27), which holding element (27) is provided with guides (34), by means of which guides (34) the holding element (27) are *<sic. is>* displaceable, through a first actuation means (44), along guideways (43), which are disposed on the carriage (11, 12), the guides (34) and the guideways (43) having the shape of an arc of a circle, whose centres lie in the squeegee edge (35) of the squeegee.

3. Device according to claim 2, characterised in that the guideways (43) are disposed on at least one lever (36; 37), which, by means of second actuation means (48), is pivotable about a pivot axis (39) provided fixed in the carriage (11, 12), directed parallel to the squeegee edge (35).

4. Device according to claim 2 or 3, characterised in that the holding element (27) for receiving the squeegee (13) or (14) consists essentially of a square profile (28) on which the squeegee (13) or (14), whose length corresponds essentially to the length of the printing screen (16) to be coated, can be hung up lengthwise, and which square profile (28) is provided in the middle area with two side walls (31) and (32) standing transversely to the longitudinal alignment, in which side walls (31, 32) the guides are provided on the outside in the form of grooves (34), which grooves (34) run along the corresponding arc of a circle.

5. Device according to claim 4, characterised in that on the outside on both side walls (31, 32) of the holding element (27) one lever each (36, 37) is disposed pivotable about the pivot axis (39), which levers each have an outwardly protruding, annular ring segment (43) provided in the surface turned toward the adjacent side wall (31) or (32), respectively, which segment engages in the groove (34) of the corresponding side wall (31) or (32), respectively, and in that the two pivotable levers (36, 37) are connected to each other by way of a small bridge (38).

6. Device according to one of the claims 2 to 5, characterised in that the first actuation means for movement of the holding element (27) along the guideways (43) consist of a first cylinder (44) which can be actuated pneumatically, whose one end (45) is pivotably connected to the carriage (11) or (12), respectively, while the other end (46) is coupled to the holding element (27), and in that the stop positions of the movable holding element (27) are dictated by the end limits of stroke of the cylinder (44).

7. Device according to one of the claims 3 to 6, characterised in that the second actuation means for pivoting the pivotable lever (36, 37) about the pivot axis (39) comprise a second cylinder (48) which can be actuated pneumatically, whose one end (49) is pivotably connected to the carriage (11) ) or (12), respectively, while the other end (50) is coupled to the pivotable lever (36, 37), and in that the end positions of the pivot movement are dictated by the end limits of stroke of the cylinder (48).

8. Device according to claim 7, characterised in that the first and second cylinders (44) and (48), which can be actuated pneumatically, are disposed essentially parallel to each other, and in that they have a different spacing with respect to the pivot axis (39) about which the levers (36, 37) are pivotable.

9. Device according to one of the claims 1 to 8, characterised in that the standing frame (1) has two columns (2, 3), between which two columns (2, 3) the printing screen (16) to be coated can be inserted and is held by holding elements (7, 17), the central area of the printing screen (16) coming to stand between the two columns (2, 3), and in that one carriage each (11) or (12), respectively, is movable along the column (2) or (3), respectively, individually or jointly with the other carriage (12) or (11), respectively, for acceptance of a squeegee (13) or (14), respectively, through driving means (19, 20, 21, 22, 23, 24, 25, 26).

## Revendications

1. Dispositif pour le revêtement des écrans d'impression, ledit dispositif comprenant un cadre support vertical muni des supports pour le maintien vertical de l'écran d'impression à revêtir et dans lequel sont disposés des chariots mobiles verticalement, des racloirs pouvant être fixés auxdits chariots, les racloirs étant pivotants autour d'axes de pivotement disposés sur les arêtes avant des racloirs afin des les amener ou les retirer pour le revêtement de l'écran, caractérisé en ce que chacun des racloirs mobiles (13,14) par-dessus la surface avant, respectivement la surface arrière de l'écran à revêtir (16) est maintenu dans la région centrale de son extension longitudinale par un des chariots mobiles verticalement (11), respectivement (12), alors que les régions d'extrémités sont libres.

2. Dispositif selon la revendication 1, caractérisé en ce que le racloir (13,14) peut être introduit dans un support (27), ledit support étant muni de moyens de guidage (34), par lequel moyen de guidage (34) le support (27) peut être déplacé le long de rails de guidage (43) disposés sur les chariots (11,12) par des premiers moyens d'actionnement (44), les moyens de guidage (34) et les rails de guidage (43) ayant la forme d'un arc de cercle, dont les centres sont situés sur l'arête de raclage (35) des racloirs.

3. Dispositif selon la revendication 2, caractérisé en ce que les rails de guidage (43) sont disposés sur au moins un levier (36;37) fixé au chariot (11; 12) et pivotant autour d'un axe de pivotement (39) parallèle à l'arête de racloir (35) par un deuxième moyen d'actionnement (48).

4. Dispositif selon l'une des revendications 2 ou 3, caractérisé en ce que le support (27) des racloirs (13) ou (14) consiste essentiellement en un profilé à quatre pans (28), sur lequel le racloir (13) ou (14), dont la longueur comprend essentiellement la longueur de l'écran d'impression (16) à revêtir, peut être accroché longitudinalement, ledit profilé à quatre pans (28) étant muni dans la région centrale de deux parois latérales (31,32) perpendiculaires à la direction longitudinale, les moyens de guidage étant disposés sous la forme de rainures (34) sur lesdites parois latérales (31,32), lesdites rainures étant disposées le long dudit arc de cercle.

5. Dispositif selon la revendication 4, caractérisé en ce qu'un levier (36,37) pivotant autour de l'axe de pivotement (39) est disposé à l'extérieur de chacune des deux parois latérales (31,32) du support (27), comprenant chacun un segment d'anneau circulaire (43) en saillie, du côté tourné vers les surfaces des parois latérales (31,32), lequel est engagé dans la rainure (34) de la paroi correspondante (31), respectivement (32), les deux leviers pivotants (36,37) étant reliés par une traverse (38).

6. Dispositif selon l'une des revendications 2 à 5, caractérisé en ce que les premiers moyens d'actionnement pour actionner le support (27) le long des rails de guidage (43) comprennent un premier cylindre pneumatique (44), dont une extrémité (45) est reliée de manière pivotante avec le chariot (11), respectivement (12), alors que l'autre extrémité (46) est articulée sur le support (27), et en ce que les positions finales du support mobile (27) sont données par les positions finales du piston du cylindre (44).

7. Dispositif selon l'une des revendications 3 à 6, caractérisé en ce que les deuxièmes moyens d'actionnement pour faire pivoter le levier pivotant (36,37) autour de l'axe de pivotement (39) comprennent un deuxième cylindre pneumatique (48), dont une extrémité (49) est reliée de manière pivotante avec le chariot (11), respectivement (12), alors que l'autre extrémité (50) est articulée sur le levier pivotant (36,37), et en ce que les positions finales du mouvement de pivotement sont données par les positions finales du piston du cylindre (44).

8. Dispositif selon la revendication 7, caractérisé en ce que le premier et le deuxième cylindre pneumatique (44) et (48) sont disposés essentiellement parallèles entre eux, et en ce que relativement à l'axe de pivotement (39) autour duquel les leviers (36,37) sont pivotants, ils ont une distance différente.

9. Dispositif selon l'une des revendications 1 à 8, caractérisé en ce que le cadre support (1) comprend deux colonnes (2,3) entre lesquelles deux colonnes (2,3) l'écran d'impression (16) à revêtir peut être introduit et être maintenu par des supports (7,17), la région centrale de l'écran d'impression (16) venant être placée entre les deux colonnes (1,2), et en ce que les chariots (11), respectivement (12) pour recevoir un racleur (13), respectivement (14) sont mobiles le long de la colonne (2), respectivement (3), séparément ou ensemble, par des moyens d'actionnement (19,20,21,22,23,24,25,26).
